# FASCICULE DE BREVET EUROPEEN

(11) **EP 3 533 080 B1**
(45) Date de publication et mention de la délivrance du brevet: **29.06.2022**
(21) Numéro de dépôt: 17784981.7
(22) Date de dépôt: 24.10.2017
(51) Int. Cl.: H01L 21/306, H01L 31/18

(54) **PROCEDE DE FABRICATION D'UNE HETEROSTRUCTURE COMPRENANT UNE STRUCTURE CONDUCTRICE ET UNE STRUCTURE SEMI-CONDUCTRICE ET COMPORTANT UNE ETAPE DE DECOUPE PAR ELECTRO-EROSION**
VERFAHREN ZUR HERSTELLUNG EINER HETEROSTRUKTUR MIT EINER LEITFÄHIGEN STRUKTUR UND EINER HALBLEITERSTRUKTUR UND MIT EINEM SCHRITT ZUR FUNKENEROSIONSBEARBEITUNG
PROCESS FOR FABRICATING A HETEROSTRUCTURE COMPRISING A CONDUCTIVE STRUCTURE AND A SEMICONDUCTOR STRUCTURE AND INCLUDING A STEP OF ELECTRICAL DISCHARGE MACHINING

(30) Priorité: 26.10.2016 FR 1660368
(43) Date de publication de la demande: 04.09.2019
(73) Titulaire: Commissariat à l'Énergie Atomique et aux Énergies Alternatives, 75015 Paris (FR)
(72) Inventeur: LETOWSKI, Bastien, 05290 Vallouise (FR); WIDIEZ, Julie, 38000 Grenoble (FR)
(74) Mandataire: Marks & Clerk France
(86) Numéro de dépôt international: PCT/EP2017/077069
(87) Numéro de publication internationale: WO 2018/077831

(56) Documents cités:
- SALEH TANVEER ET AL: "Experimental study on improving [mu]-WEDM and [mu]-EDM of doped silicon by temporary metallic coating", INTERNATIONAL JOURNAL OF ADVANCED MANUFACTURING TECHNOLOGY, SPRINGER VERLAG, LONDON; GB, vol. 78, no. 9, 13 janvier 2015 (2015-01-13), pages 1651-1663, XP035502643, ISSN: 0268-3768, DOI: 10.1007/S00170-014-6732-4 [extrait le 2015-01-13]
- KUNIEDA M ET AL: "Improvement of EDM efficiency of silicon single crystal through ohmic contact", PRECISION ENGINEERING, ELSEVIER, AMSTERDAM, NL, vol. 24, no. 3, 1 juillet 2000 (2000-07-01), pages 185-190, XP027135121, ISSN: 0141-6359 [extrait le 2000-07-01]
- LEE SANGJU ET AL: "Effect of metal coating on machinability of high purity germanium using wire electrical discharge machining", JOURNAL OF MATERIALS PROCESSING TECHNOLOGY, ELSEVIER, NL, vol. 213, no. 6, 3 janvier 2013 (2013-01-03), pages 811-817, XP028994833, ISSN: 0924-0136, DOI: 10.1016/J.JMATPROTEC.2012.12.008
- BAMBERG ET AL: "Experimental investigation of wire electrical discharge machining of gallium-doped germanium", JOURNAL OF MATERIALS PROCESSING TECHNOLOGY, ELSEVIER, NL, vol. 197, no. 1-3, 14 décembre 2007 (2007-12-14), pages 419-427, XP022390769, ISSN: 0924-0136, DOI: 10.1016/J.JMATPROTEC.2007.06.038

## Description

Le domaine de l'invention est celui de la fabrication de dispositifs ou de packaging de composants comprenant des hétérostructures alliant des structures de matériaux ductiles et des structures de matériaux fragiles.

De manière générale, on considère un matériau comme fragile s'il se rompt sans avertissement et de façon très brutale. Sa courbe contrainte déformation demeure linéaire jusqu'à la rupture où toute l'énergie élastique emmagasinée est libérée d'un seul coup. A l'opposé, un matériau est dit ductile s'il absorbe une bonne partie de l'énergie sous forme de déformations plastiques.

Dans des applications très diverses comme la microélectronique, l'électronique de puissance ou encore le photovoltaïque..., plus particulièrement lors de la microfabrication et le packaging de composants, il est courant d'associer semi-conducteurs (matériau fragile) et métaux (matériau ductile) (pour les interconnexions par exemple). Cependant cette association devient problématique lors de la découpe. En effet, l'empilement entre un matériau fragile et un matériau ductile avec des propriétés différentes entraine une problématique complexe pour arriver à découper une telle hétérostructure.

Cette problématique est notamment rencontrée dans le cadre des dispositifs électroniques de puissance à cellule de commutation 3D verticale décrits dans la demande de brevet déposée par le Demandeur et publiée sous le n° 3028095.

Ce type de dispositif électronique de puissance à cellule de commutation 3D verticale associe plusieurs matériaux pour la réalisation de packaging 3D de composants de puissance. Dans ce contexte, des couches épaisses de métal (tel que le cuivre) sont utilisées pour l'interconnexion électrique et la conduction thermique (refroidissement) de composants de puissance réalisés en silicium. Ce qui est nommé « hétérostructure » ici correspond au sandwich Si/Cu/Si ou encore au sandwich Cu/Si/Cu/Si/Cu. Plus précisément, comme décrit dans la demande de brevet précitée, il est nécessaire de procéder à une opération de découpe des cellules de commutation préalablement formées par assemblage plaque à plaque de substrats métalliques et de substrats semi-conducteurs au niveau desquels sont réalisés des composants, les substrats métalliques pouvant typiquement avoir des épaisseurs de l'ordre de plusieurs centaines de microns. On isole après découpe, des ensembles de cellules de commutation disposées les unes à côté des autres.

La problématique de découpe a été présentée ci-dessus dans un contexte précis de type de sandwich de packaging de puissance mais peut être présente dans différents contextes, comme celui d'une cellule solaire reportée sur un substrat métallique ou de tout autre composant/couche actif(ve) ou non actif(ve) pour la réalisation de substrats multicouches, présentant au moins une couche ductile (couche métallique par exemple en Cuivre, Aluminium, Or, Argent).

La découpe standard en microélectronique est une découpe à la scie. Cette technique est bien adaptée pour les matériaux fragiles (comme les semi-conducteurs ou les céramiques) mais elle montre des limites pour des matériaux ductiles (comme le cuivre, l'aluminium ou encore le plastique) avec d'importantes bavures, copeaux et souvent des conditions de découpes très spécifiques et pas compatibles avec le matériau semi-conducteur entraînant :
- l'utilisation de lubrifiant à base d'huile ;
- des vitesses de rotation faibles pour limiter l'échauffement du métal ;
- des vitesses d'avance de découpe plus faibles qu'avec seulement un semi-conducteur.

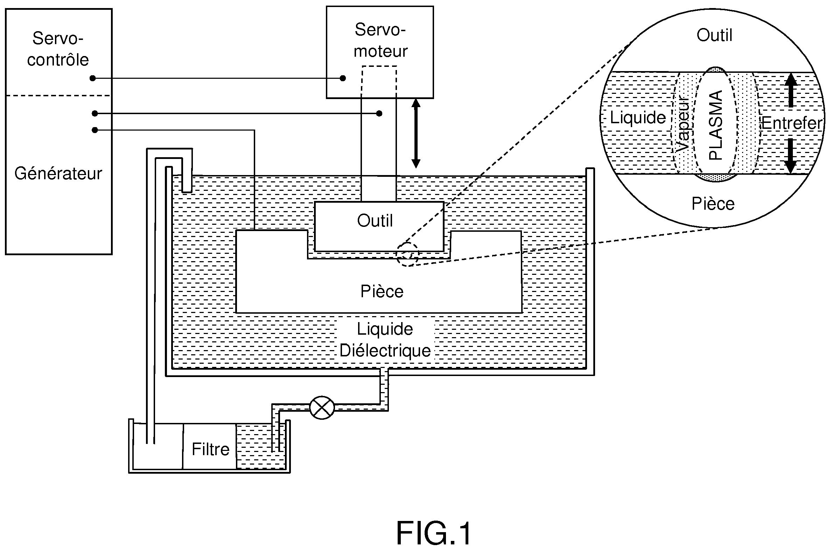

En parallèle, pour usiner des substrats conducteurs, il est connu d'utiliser une technique : l'électro-érosion, couramment dénommé « Electrical Discharge Machining » (EDM) qui est une technique de découpe de métaux très utilisée par exemple en mécanique de précision pour la fabrication d'injecteur pour les moteurs thermiques. Cette technique consiste à créer une série de décharges électriques (« sparks » en anglais), dans l'espace entre une électrode-outil et la pièce à usiner, immergées dans un diélectrique liquide. Cet espace inter-électrode est appelé entrefer ou « gap » Sur l'aspect technologique, la rugosité des flancs est contrôlée par le courant de l'arc électrique. Cette technique se caractérise par son aptitude à usiner tous les matériaux conducteurs de l'électricité (métaux, alliages, carbures, graphites, etc.) quelle que soit leur dureté. Il est classique de faire plusieurs passages avec une valeur de courant décroissante pour diminuer progressivement la rugosité des flancs de découpe. La thèse de G. Girardin, "Développement d'un procédé d'usinage par micro-électroérosion," phdthesis, Université Claude Bernard - Lyon I, 2012, explicite en détails cette technologie. La figure 1 reprend notamment le principe de l'électro-érosion d'une pièce par un outil. La pièce est plongée dans un bain, la pièce conductrice étant portée à un potentiel, l'outil étant porté à un autre potentiel de manière à créer un arc électrique. L'électrode-outil peut avantageusement être un fil métallique permettant la découpe de pièces de très petites dimensions.

Cette technique peut également être appliquée à la découpe de matériau semi-conducteur tel que le silicium mais avec une contrainte sur la résistivité. Le semi-conducteur est dopé de manière à être rendu conducteur. Cette technique est également utilisée en microfabrication pour l'usinage et le perçage de micro trous pour la réalisation de MEMS : K. Egashira and K. Mizutani, "Micro-drilling of monocrystalline silicon using a cutting tool," Precis. Eng., vol. 26, no. 3, pp. 263-268, Jul. 2002.

L'électro-érosion apporte aussi de la souplesse sur les géométries à découper. La découpe à la scie standard ne tolère que des découpes de part et d'autre d'un substrat ou d'une plaque et ne permet pas d'avoir des formes arrondies. La découpe par électro-érosion est possible pour n'importe quel type de forme, même arrondie, et peut être utile par exemple pour débiter des substrats ou des plaques circulaires dans une plaque de diamètre plus grand.

Il est à noter que l'emploi de fil de découpe lors de l'électro-érosion n'est pas systématiquement perpendiculaire à la surface à usiner et en jouant sur cet angle il est possible de réaliser un chanfrein de l'angle à la suite de la découpe, ce qui est intéressant pour un « biseau » ou « bevel » en bord de substrat.

Même si la technique d'électro-érosion se caractérise par son aptitude à usiner tous les matériaux conducteurs de l'électricité (métaux, alliages, carbures, graphites, etc.) quelle que soit leur dureté, des méthodes pour usiner des matériaux résistifs (céramiques) ont également été développées, comme décrit dans l'article de N. Mohri et al. "Assisting

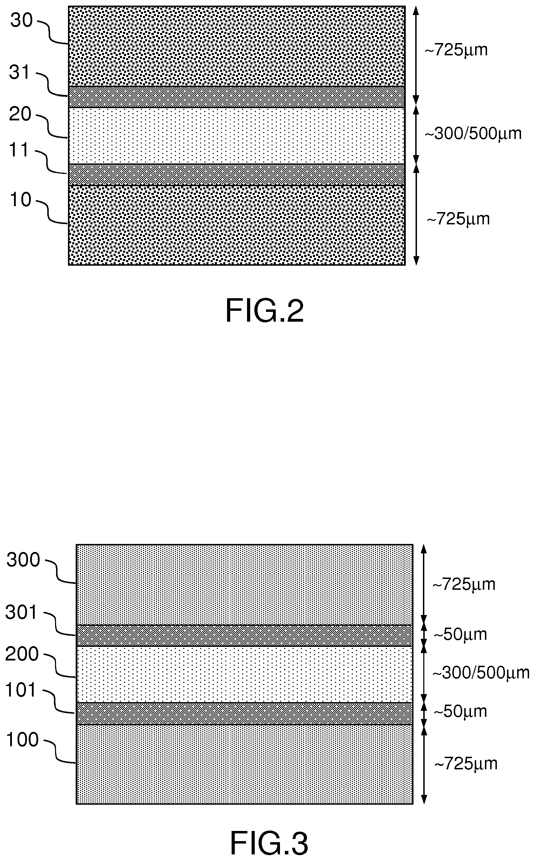

Electrode Method for Machining Insulating Ceramics", Annals of the CIRP, vol.45/1/1996. En effet, afin de pouvoir réaliser des formes, par usinage dans des pièces de céramiques, les auteurs de la publication montrent qu'en ajoutant une électrode d'assistance « assisting electrode » comme représenté en figure 2 de cet article, donc un matériau métallique conducteur sur la céramique non conductrice, il est possible de réaliser les formes désirées en surface de cette céramique. En effet, comme montré sur la figure 10 de cet article, l'électrode d'assistance entre en fusion et permet d'usiner par conduction thermique la céramique. Cependant il n'est pas question de découpe dans cet article, le courant ne traversant pas la céramique.

On connaît également l'article de T. Saleh et al, "Experimental study on improving micro-WEDM and micro-EDM of doped silicon by temporary metallic coating" dans Int. J. Adv. Manuf. Technol. (2015), vol. 78, pp1651-1663, qui décrit la découpe d'un substrat de silicium de 650 microns revêtu de fines couches d'Or.

Dans ce contexte, le Demandeur propose dans le cadre de la présente invention, une approche permettant de procéder à la découpe d'hétérostructures comprenant à la fois des structures épaisses conductrices de l'électricité type couches épaisses métalliques présentant des inconvénients de découpe standard à la scie, et des structures semiconductrices de résistivité élevée, typiquement supérieures à 1 Ω.cm et donc de résistivité telle que a priori il ne soit pas possible de découper celles-ci par électro-érosion, sans ajustement de la polarité de la surface ni dépôt métallique à la surface.

Il a déjà été décrit des procédés d'électro-érosion rendus possibles dans du Si de résistivité allant jusqu'à 15 ohm.cm (moyennant des dépôts de métaux en surface) : Takeshi Wasaki, and al.. « Micro Electro-Discharge Machining and its applications, IEEE, 1990, Y.F.Luo, C.G.Chen, Z.F.Tong « Investigation of silicon wafering by wire EDM", Journal of Materials Science 27 (1992) 58-05-5810, Dominiek Reynaerts and al. "Microstructuring of silicon electro-discharge machining (EDM) part I : theory" Elsevier Sciences (1997).

Ce type de configuration est illustrée en figure 2 et montre une hétérostructure avec :
- une première structure semi-conductrice comprenant un substrat standard en silicium non intrinsèquement dopé (NID) 10, présentant typiquement une résistivité de 5 Ω.cm, comportant en surface une zone active 11, de plus grande résistivité pouvant être comprise entre 15 Ω.cm et 50 Ω.cm. Des épaisseurs classiques sont également mentionnées à titre d'exemple : 725 µm pour le substrat 10 et 50 µm pour la couche active 11 ;
- une structure métallique épaisse 20, en cuivre pouvant typiquement présenter une épaisseur de l'ordre de 200 µm à 500 µm ;
- une seconde structure semi-conductrice identique à la première structure semi-conductrice et comprenant un substrat standard en silicium non intrinsèquement dopé 30, présentant typiquement une résistivité de 5 Ω.cm, dans lequel on réalise en surface une zone active 31, de plus grande résistivité pouvant être comprise entre 15 Ω.cm et 50 Ω.cm. Des épaisseurs classiques sont également mentionnées à titre d'exemple : 725 µm pour le substrat 30 et 50 µm pour la couche active 31.

Dans le cadre de nombreuses applications, l'épaisseur du semi-conducteur qui est active électriquement varie de quelques nanomètres en microélectronique (typiquement entre 10 et 1000 nm) à quelques micromètres en électronique de puissance (typiquement entre 1 et 100 µm), également à quelques micromètres en photovoltaïque (typiquement entre 10 et 75 µm). Cette épaisseur active du semi-conducteur en question comporte généralement des contraintes de dopage : pour améliorer la mobilité dans les couches actives des semi-conducteurs, les dopants doivent être minimisés, le film semi-conducteur est souvent soit intrinsèque soit intentionnellement faiblement dopé. La structure semi-conductrice comprenant la couche active de faible épaisseur et le substrat non intrinsèquement dopé de plus forte épaisseur présente une résistivité et donc un état non compatible avec le principe de découpe par électro-érosion, en configuration standard.

C'est pourquoi, l'hétérostructure à découper proposée dans la présente invention est une hétérostructure modifiée par rapport à l'hétérostructure décrite précédemment, de manière à ce que celle-ci soit « vue » lors du procédé de découpe comme une hétérostructure conductrice dans son ensemble, autorisant ainsi une découpe par électro-érosion.

Plus précisément, la présente invention a pour objet un procédé de fabrication d'au moins une hétérostructure élémentaire telle que définie par les termes de la revendication 1.

Selon des variantes de l'invention, les structures conductrices électriques sont en métal pouvant être du cuivre ou en alliage ou en carbure ou en graphite.

Selon des variantes de l'invention, le procédé comprend la réalisation de l'hétérostructure suivante :
- une couche de semi-conducteur pouvant être du silicium de résistivité inférieure ou égale à 10 mΩ.cm ;
- une couche de semi-conducteur pouvant être du silicium de résistivité supérieure ou égale à 1 Ω.cm ;
- une couche de métal ;
- une couche de semi-conducteur pouvant être du silicium de résistivité supérieure ou égale à 1 Ω.cm ;
- une couche de semi-conducteur pouvant être du silicium de résistivité inférieure ou égale à 10 mΩ.cm.

Selon des variantes de l'invention, les couches de semi-conducteur pouvant être du silicium de résistivité inférieure ou égale à 10 mΩ.cm ont des épaisseurs de l'ordre de plusieurs centaines de microns, les couches de semi-conducteur pouvant être du silicium de résistivité supérieure ou égale à 1 Ω.cm ayant des épaisseurs de l'ordre de quelques dizaines de microns.

Selon des variantes de l'invention, le procédé comporte la réalisation de l'hétérostructure suivante :
- une couche de métal ;
- une couche de semi-conducteur pouvant être du silicium de résistivité inférieure ou égale à 10 Ω.cm ;
- une couche de semi-conducteur pouvant être de silicium de résistivité supérieure ou égale à 1 Ω.cm ;
- une couche de métal ;
- une couche de semi-conducteur pouvant être du silicium de résistivité supérieure ou égale à 1 Ω.cm ;
- une couche de semi-conducteur pouvant être du silicium de résistivité inférieure ou égale à 10m Ω.cm ;
- une couche de métal.

Selon des variantes de l'invention le procédé comporte la réalisation de l'hétérostructure suivante :
- une couche de métal ;
- une couche de semi-conducteur pouvant être du silicium de résistivité supérieure ou égale à 1 Ω.cm ;
- une couche de métal ;
- une couche de semi-conducteur pouvant être du silicium de résistivité supérieure ou égale à 1 Ω.cm ;
- une couche de métal.

Selon des variantes de l'invention, la réalisation de l'hétérostructure comporte le collage desdites structures, ledit collage pouvant être effectué par thermo-compression. La réalisation de l'hétérostructure peut également être faite par assemblage direct conducteur (type brasage par exemple).

L'invention sera mieux comprise et d'autres avantages apparaîtront à la lecture de la description qui va suivre donnée à titre non limitatif et grâce aux figures annexées parmi lesquelles :
- la figure 1 reprend le principe connu de l'électro-érosion d'une pièce par une électrode-outil ;
- la figure 2 illustre une hétérostructure comprenant un substrat Si standard comportant une couche de haute résistivité et une couche métallique épaisse, l'ensemble ne pouvant être découpé par électro-érosion ;
- la figure 3 illustre un premier exemple d'hétérostructure pouvant être utilisée dans un procédé de l'invention ;
- la figure 4 illustre un second exemple d'hétérostructure pouvant être utilisée dans un procédé de l'invention ;
- la figure 5 illustre un troisième exemple d'hétérostructure pouvant être utilisée dans un procédé de l'invention ;
- la figure 6 illustre un quatrième exemple d'hétérostructure pouvant être utilisée dans un procédé de l'invention ;
- les figures 7a et 7b illustrent respectivement des vues au microscope de découpes respectivement à la scie et par électro-érosion d'hétérostructures de silicium et de cuivre.

Le procédé de fabrication de la présente invention permet de définir des hétérostructures élémentaires à partir d'hétérostructures de plus grandes dimensions. Ceci est notamment d'intérêt pour définir des puces centimétriques dans des plaques ou substrats standards de la microélectronique, de telles plaques pouvant présenter des dimensions typiquement de 100, 200, 300 mm de diamètre, sans que cela soit restrictif.

De manière générale, le procédé de fabrication de la présente invention permet de découper des hétérostructures de matériau fragile comme les matériaux semi-conducteurs et de matériau ductile comme les métaux, la contrainte étant que pour procéder à une opération de découpe par électro-érosion, la résistivité de la structure semi-conductrice de résistivité typiquement supérieure à 1 Ω.cm n'apparaisse pas comme une barrière à l'opération.

Pour cela, la structure semi-conductrice doit être située entre deux structures conductrices. Il peut s'agir aussi bien de structure métallique, que de structure semi-conductrice de faible résistivité, typiquement inférieure à 10 mΩ.cm. Cette structure semi-conductrice présente une épaisseur faible devant celles des structures conductrices électriques dans leur ensemble.

### Premier exemple d'hétérostructure élémentaire obtenue selon le procédé de l'invention :

On procède à l'assemblage :
- d'un premier substrat semi-conducteur 100 de faible résistivité inférieure à 10 mΩ.cm d'épaisseur pouvant typiquement être d'épaisseur égale à 725 µm assurant une fonction mécanique , présentant en surface une structure semi-conductrice 101 de résistivité élevée faiblement dopée, pouvant typiquement être de l'ordre de 20 Ω.cm et d'épaisseur de l'ordre de 50 µm ;
- d'une structure métallique 200 pouvant être en cuivre, présentant une épaisseur de l'ordre de 300 µm à 500 µm ;
- d'un second substrat semi-conducteur 300 de faible résistivité inférieure à 10 mΩ.cm d'épaisseur identique à celle du premier substrat 100 et présentant en surface une seconde structure semi-conductrice 301 de résistivité élevée, pouvant typiquement être de l'ordre de 20 Ω.cm et d'épaisseur de l'ordre de 50 µm et identique à la première structure semi-conductrice 101.

L'assemblage peut ainsi être réalisé par collage direct à température ambiante ou collage par thermocompression (avec application d'une pression et d'une température) ou encore plus classiquement par soudure, brasure etc...

La figure 3 illustre un tel assemblage. La découpe de l'ensemble par électro-érosion est rendue possible en raison de l'intégration des structures semi-conductrices 101 et 301 entre des structures conductrices électriques de résistivité inférieure à 10 mΩ.cm, 100 et 300.

Le Demandeur a réalisé des tests de découpes. La découpe de la structure illustrée en figure 2 n'a pas été possible contrairement à l'hétérostructure du premier exemple (figure 3) qui a pu être découpée avec une vitesse de découpe mesurée de 10 mm/min. Cette vitesse rend des opérations de découpes industrielles de puces centimétriques tout à fait possibles. En effet, elle est seulement trois fois plus faible que la découpe d'une structure épaisse 200 en cuivre.

### Second exemple d'hétérostructure élémentaire obtenue selon le procédé de l'invention :

On procède à l'assemblage :
- d'une première structure métallique 201 pouvant être en cuivre, présentant une épaisseur de l'ordre de 1 µm à 500 µm ;
- d'une première structure semi-conductrice 101 de résistivité élevée faiblement dopée, pouvant typiquement être de l'ordre de 20 Ω.cm et d'épaisseur de l'ordre de 50 µm ;
- d'une seconde structure métallique 200 pouvant être en cuivre, présentant une épaisseur de l'ordre de 300 µm à 500 µm ;
- d'une seconde structure semi-conductrice 301 de résistivité élevée faiblement dopée, pouvant typiquement être de l'ordre de 20 Ω.cm et d'épaisseur de l'ordre de 50 µm ;
- d'une troisième structure métallique 202 pouvant être en cuivre, présentant une épaisseur de l'ordre de 1 µm à 500 µm.

Il est à noter que les substrats du haut et du bas peuvent être très fins car ils ne jouent pas le rôle mécanique (tenu par le substrat central). Il est donc envisageable de ne faire qu'un dépôt de cuivre au lieu d'un collage d'une plaque de cuivre.

Les fines couches de semi-conducteurs faiblement dopées constituant la partie active sont généralement obtenues par épitaxie depuis un substrat standard NID. Après un collage métallique entre cette partie active et une plaque de cuivre, une opération d'amincissement jusqu'à ladite couche active permet de supprimer le substrat non actif.

Il est ensuite possible de déposer une couche de cuivre (par CVD ou PVD ou encore par électrodéposition) ou encore de réaliser un second assemblage avec 2 plaques de cuivre en haut et bas du précédent sandwich.

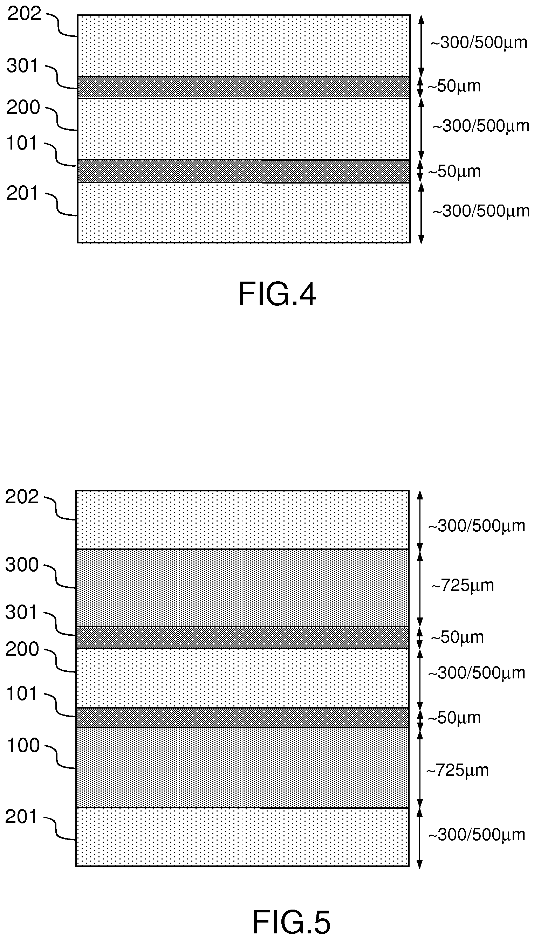

La figure 4 illustre un tel assemblage. La découpe de l'ensemble par électro-érosion est rendue possible en raison de l'intégration des structures semi-conductrices entre deux structures métalliques et donc conductrices électriques de résistivité inférieure à 1 Ω.cm.

Les épaisseurs des couches 101 et 301 sont suffisamment faibles devant les épaisseurs des couches métalliques 201/200/202 pour que l'ensemble de l'hétérostructure puisse être considéré comme suffisamment conducteur pour permettre une opération de découpe par électro-érosion.

### Troisième exemple d'hétérostructure élémentaire obtenue selon le procédé de l'invention :

On procède à l'assemblage :
- d'une première structure métallique 201 pouvant être en cuivre d'épaisseur de l'ordre de 1 µm à 500 µm ;
- d'un premier substrat semi-conducteur 100 de faible résistivité inférieure à 10 mΩ.cm d'épaisseur pouvant typiquement être d'épaisseur égale à 725 µm assurant une fonction mécanique , présentant en surface une structure semi-conductrice 101 de résistivité élevée faiblement dopée, pouvant typiquement être de l'ordre de 20 Ω.cm et d'épaisseur de l'ordre de 50 µm ;
- d'une seconde structure métallique 200 pouvant être en cuivre, présentant une épaisseur de l'ordre de 300 µm à 500 µm ;
- d'un second substrat semi-conducteur 300 identique au premier substrat 100 (résistivité inférieure ou égale à 10 mΩ.cm) et présentant en surface une seconde structure semi-conductrice 301 de résistivité élevée, pouvant typiquement être de l'ordre de 20 Ω.cm et d'épaisseur de l'ordre de 50 µm et identique à la première structure semi-conductrice 101 ;
- d'une troisième structure métallique 202 pouvant être en cuivre, présentant une épaisseur de l'ordre de 1 µm à 500 µm.

La figure 5 illustre un tel assemblage. La découpe de l'ensemble par électro-érosion est rendue possible en raison de l'intégration des structures semi-conductrices entre une structure métallique et une structure conductrice électrique de résistivité inférieure ou égale à 10 mΩ.cm.

### Quatrième exemple d'hétérostructure élémentaire obtenue selon le procédé de l'invention :

Cette hétérostructure comprend un substrat semi-conducteur 100 de faible résistivité inférieure ou égale à 10 mΩ.cm d'épaisseur pouvant typiquement être égale à 725 µm assurant une fonction mécanique, présentant en surface une structure semi-conductrice 101 de résistivité élevée faiblement dopée, pouvant typiquement être de l'ordre de 20 Ω.cm et d'épaisseur de l'ordre de 50 µm et deux couches métalliques 201 et 202 en cuivre très fines, typiquement d'épaisseur de 200 nm.

Ces très fines couches métalliques améliorent le contact ohmique lors de l'opération de découpe par électro-érosion, et les tests réalisés par le Demandeur sur cette hétérostructure avec succès mettent bien en évidence qu'il devient possible d'électro-éroder un substrat silicium (faiblement résistif, typiquement une résistivité inférieure ou égale à 10 mΩ.cm) comprenant une fine couche active de silicium peu dopé et très résistif en ayant remplacé un substrat standard NID par un tel substrat silicium.

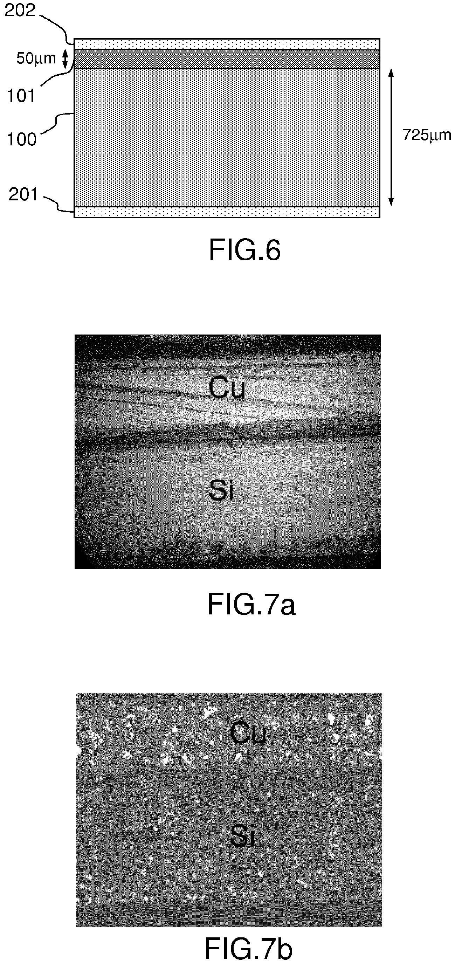

La figure 6 illustre un tel assemblage. La découpe de l'ensemble par électro-érosion est rendue possible en raison de l'intégration des structures semi-conductrices entre une structure métallique et une structure conductrice électrique de résistivité inférieure à 1 Ω.cm.

Les tests de découpe réalisés par le Demandeur ont conduit à considérer que l'épaisseur de la zone active (fortement résistive) doit rester faible devant l'épaisseur de la structure conductrice électrique. Typiquement un ratio de 10 permet de réaliser l'opération de découpe par électro-érosion. En effet, l'arc électrique et donc la fusion de la matière se fait à travers les couches faiblement résistives et c'est par conduction thermique que la fine structure plus fortement résistive entre en fusion et peut être usinée.

Les tests de découpe par électro-érosion ont été faits avec une machine AGIE de type PROGRESS V2 avec le logiciel de contrôle AGIEVISION CUT. Cette machine exploite la technique d'électro-érosion utilisant comme électrode-outil un fil métallique.

Les hétérostructures élémentaires obtenues après découpe et observées au microscope permettent de mettre en évidence la trace du type d'opération de découpe employée. A titre indicatif, les figures 7a et 7b montrent respectivement une vue au microscope d'une découpe d'hétérostructure Si/Cu réalisée à la scie et une vue au microscope d'une découpe d'hétérostructure Si/Cu réalisée par électro-érosion.

Pour distinguer si une découpe a été réalisée à la scie ou par électro-érosion, il suffit d'observer l'état de surface de la paroi découpée. L'électro-érosion induit une fusion de la matière, laissant apparaître des « gouttelettes » sur la tranche découpée. La découpe à la scie est uniquement mécanique laissant apparaître des stries/rayures.

## Revendications

1. Procédé de fabrication d'au moins une hétérostructure élémentaire comprenant :
- la réalisation d'une hétérostructure comportant au moins une structure semi-conductrice de résistivité supérieure ou égale à 1 Ω.cm située entre deux structures conductrices électriques de résistivité inférieure ou égale à 0,1Ω.cm ;
- la découpe par électro-érosion de ladite hétérostructure de manière à définir au moins ladite hétérostructure élémentaire ;
- l'épaisseur de la structure semi-conductrice étant inférieure à environ 1/10^{ième} de l'épaisseur d'au moins une desdites structures conductrices électriques ou de l'épaisseur totale desdites structures conductrices électriques,
dans lequelle la structure semi-conductrice est en silicium ou en germanium ou en matériau III-V et l'épaisseur de la structure semi-conductrice est de l'ordre de quelques dizaines de microns, l'épaisseur d'au moins une structure conductrice électrique étant d'au moins plusieurs centaines de microns.

2. Procédé de fabrication selon la revendication 1, **caractérisé en ce que** les structures conductrices électriques sont en métal pouvant être du cuivre ou en alliage ou en carbure ou en graphite.

3. Procédé de fabrication selon la revendication 1 ou la revendication 2, **caractérisé en ce qu'**il comporte la réalisation de l'hétérostructure suivante :
- une couche de semi-conducteur pouvant être du silicium de résistivité inférieure ou égale à 10 mΩ.cm ;
- une couche de semi-conducteur pouvant être du silicium de résistivité supérieure ou égale à 1 Ω.cm ;
- une couche de métal ;
- une couche de semi-conducteur pouvant être du silicium de résistivité supérieure ou égale à 1 Ω.cm ;
- une couche de semi-conducteur pouvant être du silicium de résistivité inférieure ou égale à 10 mΩ.cm.

4. Procédé de fabrication selon la revendication 3, dans lequel les couches de semi-conducteur pouvant être du silicium de résistivité inférieure ou égale à 10 mΩ.cm ont des épaisseurs de l'ordre de plusieurs centaines de microns, les couches de semi-conducteur pouvant être du silicium de résistivité supérieure ou égale à 1 Ω.cm ayant des épaisseurs de l'ordre de quelques dizaines de microns.

5. Procédé de fabrication selon l'une des revendications précédentes, **caractérisé en ce qu'**il comporte la réalisation de l'hétérostructure suivante :
- une couche de métal ;
- une couche de semi-conducteur pouvant être du silicium de résistivité inférieure ou égale à 10 Ω.cm ;
- une couche de semi-conducteur pouvant être de silicium de résistivité supérieure ou égale à 1 Ω.cm ;
- une couche de métal ;
- une couche de semi-conducteur pouvant être du silicium de résistivité supérieure ou égale à 1 Ω.cm ;
- une couche de semi-conducteur pouvant être du silicium de résistivité inférieure ou égale à 10m Ω.cm ;
- une couche de métal.

6. Procédé de fabrication selon l'une des revendications 1 ou 2, **caractérisé en ce qu'**il comporte la réalisation de l'hétérostructure suivante :
- une couche de métal ;
- une couche de semi-conducteur pouvant être du silicium de résistivité supérieure ou égale à 1 Ω.cm ;
- une couche de métal ;
- une couche de semi-conducteur pouvant être du silicium de résistivité supérieure ou égale à 1 Ω.cm ;
- une couche de métal.

7. Procédé de fabrication selon l'une des revendications précédentes dans lequel la réalisation de l'hétérostructure comporte le collage desdites structures conductrices électriques et semi-conductrice, ledit collage pouvant être effectué par thermo-compression.

## Patentansprüche

1. Verfahren zur Herstellung mindestens einer elementaren Heterostruktur, umfassend:
- Fertigung einer Heterostruktur, aufweisend mindestens eine Halbleiterstruktur mit einem Widerstand größer oder gleich 1 Ω.cm, die sich zwischen zwei elektrisch leitenden Strukturen mit einem Widerstand kleiner oder gleich 0,1 Ω.cm befindet;
- Schneiden der Heterostruktur durch Funkenerosion, um mindestens die elementare Heterostruktur zu definieren;
- wobei die Dicke der Halbleiterstruktur kleiner als etwa 1/10 der Dicke mindestens einer der elektrisch leitenden Strukturen oder der gesamten Dicke der elektrisch leitenden Strukturen ist,
wobei die Halbleiterstruktur aus Silizium oder Germanium oder einem III-V-Material besteht und die Dicke der Halbleiterstruktur in der Größenordnung von einigen zehn Mikrometern liegt, wobei die Dicke mindestens einer elektrisch leitenden Struktur mindestens mehrere hundert Mikrometer beträgt.

2. Herstellungsverfahren nach Anspruch 1, **dadurch gekennzeichnet, dass** die elektrisch leitenden Strukturen aus Metall bestehen, wobei es sich um Kupfer oder eine Legierung oder Karbid oder Graphit handeln kann.

3. Herstellungsverfahren nach Anspruch 1 oder 2, **dadurch gekennzeichnet, dass** es die Fertigung der folgenden Heterostruktur umfasst:
- eine Halbleiterschicht, die aus Silizium mit einem Widerstand kleiner oder gleich 10 mΩ.cm bestehen kann;
- eine Halbleiterschicht, die aus Silizium mit einem Widerstand größer oder gleich 1 Ω.cm bestehen kann;
- eine Metallschicht;
- eine Halbleiterschicht, die aus Silizium mit einem Widerstand größer oder gleich 1 Ω.cm bestehen kann;
- eine Halbleiterschicht, die aus Silizium mit einem Widerstand kleiner oder gleich 10 mΩ.cm bestehen kann.

4. Herstellungsverfahren nach Anspruch 3, wobei die Halbleiterschichten, die aus Silizium mit einem Widerstand kleiner oder gleich 10 mΩ.cm bestehen können, Dicken in der Größenordnung von mehreren hundert Mikrometern aufweisen, wobei die Halbleiterschichten, die aus Silizium mit einem Widerstand größer oder gleich 1 mΩ.cm bestehen können, Dicken in der Größenordnung von mehreren zehn Mikrometern aufweisen.

5. Herstellungsverfahren nach einem der vorhergehenden Ansprüche, **dadurch gekennzeichnet, dass** es die Fertigung der folgenden Heterostruktur umfasst:
- eine Metallschicht;
- eine Halbleiterschicht, die aus Silizium mit einem Widerstand kleiner oder gleich 10 Ω.cm bestehen kann;
- eine Halbleiterschicht, die aus Silizium mit einem Widerstand größer oder gleich 1 Ω.cm bestehen kann;
- eine Metallschicht;
- eine Halbleiterschicht, die aus Silizium mit einem Widerstand größer oder gleich 1 Ω.cm bestehen kann;
- eine Halbleiterschicht, die aus Silizium mit einem Widerstand kleiner oder gleich 10 mΩ.cm bestehen kann;
- eine Metallschicht.

6. Herstellungsverfahren nach einem der Ansprüche 1 oder 2, **dadurch gekennzeichnet, dass** es die Fertigung der folgenden Heterostruktur umfasst:
- eine Metallschicht;
- eine Halbleiterschicht, die aus Silizium mit einem Widerstand größer oder gleich 1 Ω.cm bestehen kann;
- eine Metallschicht;
- eine Halbleiterschicht, die aus Silizium mit einem Widerstand größer oder gleich 1 Ω.cm bestehen kann;
- eine Metallschicht.

7. Herstellungsverfahren nach einem der vorhergehenden Ansprüche, wobei die Fertigung der Heterostruktur das Kleben der elektrisch leitenden Strukturen und Halbleiterstrukturen umfasst, wobei das Kleben durch Thermokompression ausgeführt werden kann.

## Claims

1. A method for fabricating at least one elementary heterostructure comprising:
- producing a heterostructure having at least one semiconductor structure of resistivity higher than or equal to 1 Ω.cm located between two electrically conductive structures of resistivity lower than or equal to 0.1 Ω.cm;
- cutting said heterostructure by electrical discharge machining so as to define at least said elementary heterostructure;
- the thickness of the semiconductor structure being smaller than about 1/10^{th} of the thickness of at least one of said electrically conductive structures or of the total thickness of said electrically conductive structures,
wherein the semiconductor structure is made of silicon or of germanium or of III-V material and the thickness of the semiconductor structure is about a few tens of microns, the thickness of at least one electrically conductive structure being at least several hundred microns.

2. The fabrication method according to claim 1, **characterised in that** the electrically conductive structures are made of metal, possibly copper, or of an alloy or of carbide or of graphite.

3. The fabrication method according to claim 1 or claim 2, **characterised in that** it involves producing the following heterostructure:
- a semiconductor layer, possibly of silicon, of resistivity lower than or equal to 10 mΩ.cm;
- a semiconductor layer, possibly of silicon, of resistivity higher than or equal to 1 Ω.cm;
- a metal layer;
- a semiconductor layer, possibly of silicon, of resistivity higher than or equal to 1 Ω.cm;
- a semiconductor layer, possibly of silicon, of resistivity lower than or equal to 10 mΩ.cm.

4. The fabrication method according to claim 3, wherein the semiconductor layers, possibly of silicon, of resistivity lower than or equal to 10 mΩ.cm have thicknesses of about several hundred microns, the semiconductor layers, possibly of silicon, of resistivity higher than or equal to 1 Ω.cm, having thicknesses of about a few tens of microns.

5. The fabrication method according to any one of the preceding claims, **characterised in that** it involves producing the following heterostructure:
- a metal layer;
- a semiconductor layer, possibly of silicon, of resistivity lower than or equal to 10 Ω.cm;
- a semiconductor layer, possibly of silicon, of resistivity higher than or equal to 1 Ω.cm;
- a metal layer;
- a semiconductor layer, possibly of silicon, of resistivity higher than or equal to 1 Ω.cm;
- a semiconductor layer, possibly of silicon, of resistivity lower than or equal to 10 mΩ.cm;
- a metal layer.

6. The fabrication method according to any one of claims 1 or 2, **characterised in that** it involves producing the following heterostructure:
- a metal layer;
- a semiconductor layer, possibly of silicon, of resistivity higher than or equal to 1 Ω.cm;
- a metal layer;
- a semiconductor layer, possibly of silicon, of resistivity higher than or equal to 1 Ω.cm;
- a metal layer.

7. The fabrication method according to one of the preceding claims, wherein the production of the heterostructure involves bonding said electrically conductive and semiconductor structures, said bonding possibly being achieved by thermo-compression.
